# EUROPÄISCHE PATENTSCHRIFT

(11) **EP 4 082 755 B1**
(45) Veröffentlichungstag und Bekanntmachung des Hinweises auf die Patenterteilung: **09.10.2024**
(21) Anmeldenummer: 22170161.8
(22) Anmeldetag: 27.04.2022
(51) Int. Cl.: B29C 64/194, B29C 64/393, B33Y 30/00, B33Y 40/00, B33Y 50/02, B29C 64/135, B33Y 10/00, G03F 7/00, G03F 7/20

(54) **VERFAHREN ZUM ERZEUGEN EINER DREIDIMENSIONALEN STRUKTUR IN EINEM LITHOGRAPHIEMATERIAL MITTELS EINER LASERLITHOGRAPHIE-VORRICHTUNG UND LASERLITHOGRAPHIE-VORRICHTUNG**
METHOD FOR PRODUCING A THREE-DIMENSIONAL STRUCTURE IN A LITHOGRAPHIC MATERIAL BY MEANS OF A LASER LITHOGRAPHY DEVICE AND LASER LITHOGRAPHY DEVICE
PROCÉDÉ DE GÉNÉRATION D' UNE STRUCTURE TRIDIMENSIONNELLE DANS UNE MATIÈRE DE LITHOGRAPHIE AU MOYEN D' UN DISPOSITIF DE LITHOGRAPHIE LASER ET MOYEN D' UN DISPOSITIF DE LITHOGRAPHIE

(30) Priorität: 28.04.2021 DE 102021110860
(43) Veröffentlichungstag der Anmeldung: 02.11.2022
(73) Patentinhaber: Nanoscribe Holding GmbH, 76344 Eggenstein-Leopoldshafen (DE)
(72) Erfinder: Lindenmann, Nicole, 75223 Niefern-Öschelbronn (DE); Blaicher, Matthias, 76297 Stutensee (DE); Hoffmann, Jörg, 67363 Lustadt (DE)
(74) Vertreter: DREISS Patentanwälte PartG mbB

(56) Entgegenhaltungen:
- EP-B1- 3 083 205
- US-A1- 2016 101 573
- US-A1- 2019 163 067
- US-A1- 2020 001 541

## Beschreibung

Die Erfindung betrifft ein Verfahren zum Erzeugen einer dreidimensionalen Zielstruktur in einem Lithographiematerial mittels einer Laserlithographie-Vorrichtung. Die Erfindung betrifft auch eine für das Verfahren angepasste Laserlithographie-Vorrichtung. Derartige Techniken finden insbesondere Verwendung bei der Erzeugung von Mikro- oder Nanostrukturen in Bereichen, in welchen hohe Präzision und gleichzeitig Gestaltungsfreiheit für die zu erzeugende Struktur erwünscht sind. Bei solchen Laserlithographie-Verfahren erfolgt das Schreiben einer Struktur üblicherweise dadurch, dass in einem Fokusbereich eines Laser-Schreibstrahls eine Belichtungsdosis in ein Lithographiematerial eingestrahlt und somit lokal ein Strukturbereich definiert wird, beispielsweise indem das Lithographiematerial lokal ausgehärtet oder polymerisiert wird. Durch Verlagerung des Fokusbereiches in dem Lithographiematerial kann dann eine dreidimensionale Gesamtstruktur erzeugt werden.

US 2019/163067 A1 offenbart ein Verfahren zur lithographischen Erzeugung einer Zielstruktur an einer nichtplanaren Ausgangsstruktur durch Belichten eines Photoresists mittels mindestens eines Lithographiestrahls, umfassend die folgenden Schritte:
a) Erfassen einer Topographie einer Oberfläche einer nichtplanaren Ausgangsstruktur;
b) Verwenden mindestens eines Test-Parameters für den Lithographiestrahl und Ermitteln einer Wechselwirkung des Lithographiestrahls mit der Ausgangsstruktur sowie der hierdurch hervorgerufenen Veränderung des Lithographiestrahls und/oder der zu erzeugenden Zielstruktur;
c) Bestimmen mindestens eines Korrektur-Parameters für den Lithographiestrahl derart, dass die durch die Wechselwirkung des Lithographiestrahls mit der Ausgangsstruktur verursachte Veränderung des Lithographiestrahls und/oder der zu erzeugenden Zielstruktur verringert wird; und
d) Erzeugen der gewünschten Zielstruktur an der Ausgangsstruktur durch Belichten des Photoresists mittels des mindestens einen Lithographiestrahls unter Verwendung des mindestens einen Korrektur-Parameters für den Lithographiestrahl.

Aus der DE 10 2017 110 241 A1 ist ein Laserlithographie-Verfahren bekannt, bei dem eine Oberfläche einer gewünschten Struktur durch lokale Veränderung in der eingestrahlten Belichtungsdosis (Belichtungsvariation) erzeugt wird.

Um unter Verwendung einer solchen Belichtungsvariation Strukturen mit hoher Genauigkeit erzeugen zu können, muss ein Zusammenhang zwischen der Belichtungsdosis und dem Belichtungsergebnis hergestellt werden. Hierfür ist üblicherweise ein entsprechender Kalibrationsprozess erforderlich. Zu diesem Zweck ist es bekannt, vor dem eigentlichen Schreiben einer gewünschten Struktur Referenzstrukturen mit vorgegebenen Belichtungsdosen zu erzeugen, diese dann zu entwickeln und im Anschluss deren Oberfläche optisch oder mechanisch auszumessen. In Abhängigkeit der Messergebnisse wird dann üblicherweise die Belichtungsdosis entsprechend angepasst und der Prozess iterativ wiederholt, bis das erzielte Ergebnis den vorgegebenen Anforderungen entspricht. Ein solcher Optimierungsprozess ist jedoch in der Regel zeitaufwendig und schwierig zu automatisieren. Zudem muss ein solcher Kalibrationsprozess üblicherweise in bestimmten zeitlichen Abständen erneut ausgeführt werden.

US 2016/0101573 A1 beschreibt ein Verfahren zum Herstellen einer ophthalmischen Linse, wobei eine Korrekturmaßnahme durchgeführt wird, wenn eine ermittelte Ist-Hüllkurve der hergestellten Linse von einer Soll-Hüllkurve abweicht.

US 2020/0001541 A1 beschreibt ein Lithographieverfahren, bei dem die Krümmung einer noch flüssigen Aushärteschicht eines Volumens an Lithographiematerial ermittelt wird. In Abhängigkeit von der ermittelten Krümmung werden Prozessparameter eingestellt.

Der Erfindung liegt die Aufgabe zugrunde, auf einfache und schnelle Weise eine dreidimensionale Struktur mit hoher Präzision in einem Lithographiematerial zu erzeugen.

Diese Aufgabe wird durch ein Verfahren gemäß Anspruch 1 gelöst. Hierbei handelt es sich um ein Laserlithographie-Verfahren, insbesondere sogenanntes direktes Laserschreiben, mittels einer Laserlithographie-Vorrichtung in einem Volumen an Lithographiematerial bzw. in einem mit Lithographiematerial ausgefüllten Volumen. Gemäß dem Verfahren wird eine Zielstruktur in dem Lithographiematerial dadurch geschrieben, bzw. definiert, dass sequenziell eine Mehrzahl von sich insgesamt zu der Zielstruktur ergänzenden Strukturbereichen (im Folgenden auch "Voxel" genannt) definiert wird (d.h. mit der Laserlithographie-Vorrichtung in das Lithographiematerial "geschrieben" wird).

Zum Schreiben der Strukturbereiche und somit der Zielstruktur durchläuft ein Fokusbereich eines Laser-Schreibstrahls eine Scan-Mannigfaltigkeit durch das Lithographiematerial. Die Scan-Mannigfaltigkeit ist erfindungsgemäß eine Scan-Kurve, kann jedoch auch komplexer ausgeführt sein. Mit anderen Worten wird der Fokusbereich des Laser-Schreibstrahls durch das Lithographiematerial verlagert. Der Laser-Schreibstrahl ist zu diesem Zweck innerhalb eines Schreibbereichs der Laserlithographie-Vorrichtung mit der für die Zwecke der Strukturierung erforderlichen Präzision steuerbar. Beispielsweise kann der Laser-Schreibstrahl mittels einer Strahlführungseinrichtung kontrolliert abgelenkt werden. Denkbar ist aber auch, dass das Lithographiematerial oder ein Substrat mit dem Lithographiematerial mittels einer Positioniereinrichtung kontrolliert relativ zu dem Laser-Schreibstrahl verlagert wird. Beide Konzepte zur Verlagerung können auch gemeinsam angewendet werden.

In dem Fokusbereich des Laser-Schreibstrahls wird eine Belichtungsdosis in das Lithographiematerial eingestrahlt, wobei unter Ausnutzung von Multi-Photonen-Absorption das Lithographiematerial lokal verändert und somit ein Strukturbereich erzeugt bzw. geschrieben wird. Das Lithographiematerial wird insofern unter Ausnutzung von Multi-Photonen-Absorption lokal strukturiert. Insbesondere wird das Lithographiematerial durch Einstrahlen der Belichtungsdosis des Laser-Schreibstrahls chemisch und/oder physikalisch verändert, beispielsweise ausgehärtet oder polymerisiert. Die Belichtungsdosis ist insbesondere eine Volumendosis an Strahlungsenergie. Die Größe des veränderten Strukturbereichs ("Voxels") im Lithographiematerial hängt von der Belichtungsdosis ab.

Durch Variation der Belichtungsdosis kann somit die räumliche Ausdehnung des jeweiligen Strukturbereichs bzw. Voxels, insbesondere eine Strukturhöhe, verändert werden. Das Einbringen der Belichtungsdosis mittels Multi-Photonen-Absorption ist bei der vorliegend angewandten Art des 3D-Laserschreibens besonders vorteilhaft. Hierzu ist das Lithographiematerial derart ausgebildet und der Laser-Schreibestrahl derart auf das Lithographiematerial abgestimmt, dass eine Veränderung des Lithographiematerials (zum Beispiel lokale Polymerisation) nur mittels Absorption mehrerer Photonen möglich ist. Hierzu kann beispielsweise die Wellenlänge des Laser-Schreibstrahls derart gewählt (und damit die zugeordnete Quantenenergie derart bemessen sein), dass der für die Veränderung des Lithographiematerials erforderliche Energieeintrag nur durch gleichzeitige Absorption zweier oder mehrerer Quanten erreicht wird. Die Wahrscheinlichkeit für einen solchen Prozess ist nichtlinear intensitätsabhängig und im Fokusbereich gegenüber dem übrigen Schreibstrahl deutlich erhöht. Aus grundsätzlichen Überlegungen ergibt sich, dass die Wahrscheinlichkeit zur Absorption von zwei oder mehr Quanten vom Quadrat oder einer höheren Potenz der Strahlungsintensität abhängen kann. Im Gegensatz hierzu weist die Wahrscheinlichkeit für lineare Absorptionsprozesse eine andere Intensitätsabhängigkeit auf, insbesondere mit einer geringeren Potenz der Strahlungsintensität. Da beim Eindringen des Laser-Schreibstrahls in das Lithographiematerial eine Dämpfung erfolgt (zum Beispiel gemäß dem Beer'schen Gesetz), wäre ein Schreiben im Fokusbereich unter Ausnutzung linearer Absorptionsprozesse tief unter der Flüssigkeitsoberfläche des Lithographiematerials problematisch, da aufgrund der Dämpfung selbst bei einer Fokussierung unterhalb der Oberfläche in dem Fokusbereich nicht zwingend die höchste Absorptionswahrscheinlichkeit vorliegt. Der Mechanismus der Multi-Photonen-Absorption ermöglicht es hingegen, auch im Inneren eines Volumens aus Lithographiematerial, also auch vergleichsweise tief unter der Flüssigkeitsoberfläche, die gewünschte Belichtungsdosis einzubringen und das Lithographiematerial lokal zu verändern. Vorrichtungen zum schrittweisen Absenken einer Trägerstruktur in einem Bad aus Lithographiematerial, wie es im Stand der Technik bekannt ist, ist somit nicht erforderlich.

Zur Lösung der Aufgabe wird insbesondere vorgeschlagen, dass zunächst wenigstens ein Belichtungsdatensatz bereitgestellt wird, welcher für die Scan-Mannigfaltigkeit ortsabhängig eine lokale Belichtungsdosis repräsentiert (Schritt a). Insbesondere kann der wenigstens eine Belichtungsdatensatz für jeden Scanpunkt entlang einer Scankurve des Laser-Schreibstrahls durch das Lithographiematerial eine lokale Belichtungsdosis repräsentieren. Der wenigstens eine Belichtungsdatensatz gibt insofern vor, mit welcher Belichtungsdosis an einer bestimmten Position der Scan-Mannigfaltigkeit eingestrahlt werden soll. Der wenigstens eine Belichtungsdatensatz ist insbesondere in einem Speicher einer Steuereinrichtung der Laserlithographie-Vorrichtung hinterlegt oder hinterlegbar.

Das Bereitstellen des wenigstens ein Belichtungsdatensatzes kann insbesondere dadurch erfolgen, dass ein die zu erzeugende Zielstruktur repräsentierender Strukturdatensatzes (z.B. Beispiel CAD-Daten) bereitgestellt bzw. in einer Steuereinrichtung hinterlegt wird und anschließend daraus der wenigstens eine Belichtungsdatensatz rechnergestützt ermittelt wird, beispielsweise mittels einer dazu eingerichteten Steuereinrichtung der Laserlithographie-Vorrichtung.

In einem weiteren Schritt wird dann auf Basis des wenigstens einen Belichtungsdatensatzes eine die Zielstruktur annähernde Struktur in dem Lithographiematerial definiert bzw. erzeugt (Schritt b). Insbesondere wird hierzu die Laserlithographie-Vorrichtung gemäß dem wenigstens einen Belichtungsdatensatz angesteuert, sodass sequenziell Strukturbereiche in dem Lithographiematerial entsprechend der durch den wenigstens einen Belichtungsdatensatz vorgegebenen Belichtungsdosis geschrieben werden.

Sodann wird zumindest ein Abschnitt der bereits definierten Struktur mittels eines ortsauflösenden bildgebenden Messverfahrens analysiert (Schritt c). Es ist denkbar, dass die Struktur erst nach Abschluss des Schreibvorgangs analysiert wird. Es ist auch denkbar, dass die zu analysierende Struktur bereits während des Definierens (sozusagen "online") analysiert wird. Insbesondere wird eine Topographie bzw. Form der definierten Struktur gemessen. Insbesondere kann eine Bildaufzeichnung mittels einer optischen Messeinrichtung erfolgen, beispielsweise auf Basis von OCT (optical coherence tomography). Es ist möglich, dass die komplette bereits definierte Struktur analysiert wird. Es ist aber auch möglich, dass nur Teilbereiche der bereits definierten Struktur analysiert werden, bspw. solche, die besonderer Optimierung bedürfen (z.B. Übergangsbereiche, die durch das Aneinandersetzen von Teilstrukturen aufgrund eines begrenzten Schreibbereichs entstehen, s.u.).

Während oder nach dem Analysieren der Struktur wird rechnergestützt wenigstens ein Analysedatensatz ermittelt, welcher die analysierte Struktur, insbesondere deren Form bzw. Topographie, repräsentiert.

Im Anschluss wird dann rechnergestützt ein Abweichungsdatensatz ermittelt, welcher Abweichungen, insbesondere in der Topographie bzw. Form, der bereits definierten Struktur von der Zielstruktur repräsentiert (Schritt d). Das Ermitteln des Abweichungsdatensatzes erfolgt insbesondere durch Vergleich des wenigstens einen Analysedatensatzes mit einem die zu erzeugende Zielstruktur repräsentierenden Strukturdatensatz. Bei diesem Strukturdatensatz kann es sich insbesondere um den wenigstens einen Belichtungsdatensatz handeln. Unter Abweichungen wird insbesondere eine Differenz zwischen der Soll-Topographie der Zielstruktur und der Ist-Topographie der auf Basis des wenigstens einen Belichtungsdatensatzes definierten Struktur verstanden.

In einem weiteren Schritt (Schritt e) wird, insbesondere auf Basis des Abweichungsdatensatzes, wenigstens ein Korrektur-Belichtungsdatensatz rechnergestützt ermittelt, welcher für die Scan-Mannigfaltigkeit ortsabhängig eine zum Ausgleich der Abweichungen erforderliche Korrektur-Belichtungsdosis repräsentiert.

Sodann wird auf Basis des wenigstens einen Korrektur-Belichtungsdatensatzes eine Korrekturstruktur erzeugt (Schritt f).

Es ist denkbar, dass auf Basis des Korrektur-Belichtungsdatensatzes eine separate, insbesondere von der auf Basis des Belichtungsdatensatzes definierten Struktur räumlich getrennte, Struktur erzeugt wird. Dann kann der wenigstens eine Korrektur-Belichtungsdatensatz insbesondere für die Scan-Mannigfaltigkeit ortsabhängig eine Belichtungsdosis vorgeben, wobei die Belichtungsdosis derart ermittelt ist, dass eine auf Basis des Korrektur-Belichtungsdatensatzes geschriebene Struktur eine geringere Abweichung von der Zielstruktur aufweist aus die zuvor auf Basis des Belichtungsdatensatzes geschriebene Struktur von der Zielstruktur. Es ist auch möglich, dass die Korrekturstruktur der Nachkorrektur der zunächst auf Basis des wenigstens ein Belichtungsdatensatzes geschriebenen Struktur dient. Dann kann der wenigstens eine Korrektur-Belichtungsdatensatz insbesondere für die Scan-Mannigfaltigkeit ortsabhängig eine Belichtungsdosis vorgeben, wobei die Belichtungsdosis derart ermittelt ist, dass durch Schreiben einer Struktur auf Basis des Korrektur-Belichtungsdatensatzes eine Abweichung zwischen der bereits definierten Struktur und der Zielstruktur verringert wird. Beispielsweise kann die Korrekturstruktur auf die bereits geschriebene Struktur aufgetragen werden.

Ein solches Verfahren ermöglicht es, eine bereits geschriebene Struktur in-situ zu charakterisieren und Abweichungen von einer gewünschten Zielstruktur direkt auszubessern. Hierdurch können mit vergleichsweise geringem Zeitaufwand und apparativem Aufwand Strukturen mit hoher Genauigkeit erzeugt werden. Insbesondere ermöglicht es das Verfahren, eine Abweichung von einer gewünschten Zielstruktur direkt an der bereits erzeugten Struktur zu detektieren und zwar ohne, dass die Struktur zuvor für die Analyse vorbereitet werden muss.

Insbesondere erfolgt zwischen dem Definieren der Struktur (Schritt b) und dem Analysieren der Struktur (Schritt c) keine Entwicklung des Lithographiematerials. Es wird also insbesondere kein unbelichtetes Lithographiematerial entfernt oder die auf Basis des Belichtungsdatensatzes bereits erzeugte Struktur ausgehärtet. Mit einem solchen Verfahren kann somit eine geschriebene Struktur in-situ optimiert werden, was schnellere Zykluszeiten ermöglicht. Insbesondere ermöglicht es das Verfahren, eine Strukturoptimierung zu automatisieren, da aufwändige Entwicklungsschritte entfallen.

Die Veränderung der Belichtungsdosis (Belichtungsvariation) kann durch Lasermodulation, z.B. mittels aus dem Stand der Technik bekannten akustooptischen Modulatoren oder mittels automatisierten Polarisatoren erfolgen. Die Belichtungsvariation kann auch durch andere Strahlformungs-Methoden erfolgen, bei denen Amplitude, Phase oder Polarisation des eingestrahlten Laser-Schreibstrahls eingestellt werden können.

Als Lithographiematerial werden im vorliegenden Zusammenhang grundsätzlich solche Substanzen bezeichnet, deren chemische und/oder physikalische Materialeigenschaften durch die Bestrahlung mit einem Laser-Schreibstrahl veränderbar sind, beispielsweise sogenannte Lithographielacke. Je nach Art der durch den Schreibstrahl induzierten Veränderungen können Lithographiematerialien in sogenannte Negativlacke (bei welchem durch Bestrahlung eine lokale Aushärtung erfolgt oder die Löslichkeit in einem Entwicklermedium verringert wird) und in sogenannte Positivlacke (bei welchem durch die Bestrahlung lokal die Löslichkeit in einem Entwicklermedium erhöht wird) unterschieden werden.

Gemäß einer vorteilhaften Weiterbildung werden die Schritte c) bis f) des vorstehend erläuterten Verfahrens, also das Analysieren der Struktur und das Ermitteln des wenigstens einen Analysedatensatzes (Schritt c), das Ermitteln eines Abweichungsdatensatzes (Schritt d), das Ermitteln wenigstens eines Korrektur-Belichtungsdatensatzes (Schritt e) sowie das Definieren der Korrekturstruktur (Schritt f), iterativ wiederholt, sodass die Abweichung einer tatsächlich definierten Struktur von der gewünschten Zielstruktur zunehmend, d.h. im Rahmen jeder Iteration, verringert wird. Mit anderen Worten wird also nach dem Schreiben der Korrekturstruktur die sich dann ergebende Struktur erneut analysiert und gegebenenfalls eine weitere Korrekturstruktur geschrieben. Vorzugsweise werden die Schritte c) bis f) so oft iterativ wiederholt, bis die ermittelte Abweichung einen vorgegebenen oder vorgebbaren, insbesondere in einer Steuereinrichtung hinterlegten oder hinterlegbaren, Schwellwert unterschreitet.

Bei dem zur Analyse der definierten Struktur verwendeten bildgebenden Messverfahren kann es sich insbesondere um ein optisches Mikroskopieverfahren handeln, weiter insbesondere um nichtlineare Mikroskopie. Es ist beispielsweise denkbar, dass die zu analysierende Struktur zunächst mit Anregungslicht beleuchtet wird und die von der zu analysierenden Struktur rückgestreute, reflektierte oder transmittierte reflektierte Strahlung mittels einer optischen Messeinrichtung detektiert wird. Die Messeinrichtung kann insbesondere eine Messoptik umfassen, welche vorzugsweise konfokal zu der den Laser-Schreibstrahl erzeugenden Einrichtung (z.B. Strahlführungseinrichtung) ausgebildet ist. Besonders vorteilhaft kann es auch sein, wenn der Laser-Schreibstrahl zum Definieren einer Struktur durch ein Objektiv in das Lithographiematerial eingestrahlt wird und dieses Objekt auch zur Sammlung der von der zu analysierenden Struktur ausgesendeten Strahlung verwendet wird. Grundsätzlich ist es aber auch möglich, dass zum Mikroskopieren eine separate Messeinrichtung, insbesondere ein separates Objektiv, verwendet wird.

Insbesondere erfolgt das Analysieren der Struktur mittels konfokaler Fluoreszenzmikroskopie. Insofern wird insbesondere ein Fluoreszenzsignal ausgewertet, welches beim Einstrahlen von Anregungslicht in das Lithografiematerial von dem Lithographiematerial erzeugt wird. Je nachdem ob das Lithographiematerial in seinem unveränderten Ausgangszustand (bspw. in einem unpolymerisierten Zustand) oder in einem durch den Laser-Schreibstrahl veränderten Zustand (bspw. in einem polymerisierten Zustand) vorliegt, werden unterschiedliche Fluoreszenzsignale erzeugt, sodass ein Strukturkontrast detektiert werden kann.

Eine besonders vorteilhafte Ausgestaltung des Verfahrens kann ferner darin bestehen, dass zum Analysieren der bereits definierten Struktur diese mit dem Laser-Schreibstrahl optisch abgetastet wird und zur Bildgebung die rückgestreute, reflektierte, transmittierte oder durch Fluoreszenz erzeugte Strahlung mittels einer Messeinrichtung detektiert wird. Insofern wird der Laser-Schreibstrahl dazu verwendet, die zu analysierende Struktur mit Anregungslicht zu beleuchten. Diese Abtastung mit dem Laser-Schreibstrahl selbst hat den Vorteil, dass keine zusätzlichen bildgebenden Einrichtungen erforderlich sind. Zudem kann auf diese Weise eine Analyse besonders schnell erfolgen, da insbesondere kein Umbau der Optik erforderlich ist. Zum Abtasten der Struktur wird die Belichtungsdosis vorzugsweise derart niedrig gewählt, dass beim Abtasten keine Struktur in dem Lithographiematerial definiert wird.

Insbesondere wird eine Laserintensität gewählt, die unterhalb des Schwellwerts liegt, bei dem eine nennenswerte Polymerisation des Lithographiematerials erfolgt (Polymerisationsthreshold). Es ist auch möglich, dass die zu untersuchende Struktur mit Laserlicht einer anderen Laserwellenlänge beleuchtet wird, welche eine derart geringe lineare oder nichtlineare Absorption in dem Lithographiematerial aufzeigt, dass beim Abtasten keine Struktur in dem Lithographiematerial definiert wird.

Zusätzlich oder alternativ kann die bereits definierte Struktur auch dadurch analysiert werden, dass diese - nach Art eines Rasterkraftmikroskops - mittels einer Abtastspitze, bspw. in Form einer Nadel, mechanisch abgetastet wird. Eine solche Ausgestaltung ist insbesondere bei im Ausgangszustand flüssigen Lithographiematerialien von Vorteil.

Gemäß einer vorteilhaften Weiterbildung kann die Zielstruktur dadurch definiert werden, dass sequenziell eine Mehrzahl von Teilstrukturen definiert werden, welche zusammen die Zielstruktur zumindest annähern. Eine solche Ausgestaltung ist insbesondere dann vorteilhaft, wenn die zu erzeugende Zielstruktur größer ist als der maximale Schreibbereich der Laserlithographie-Vorrichtung. Zur Erzeugung der Teilstrukturen wird die Zielstruktur vorzugsweise rechnerisch gerastert, insbesondere in Strukturbereiche (Voxel) zerlegt und die Teilstrukturen jeweils durch eine vorzugsweise zusammenhängende Menge von Strukturbereichen (Voxel) gebildet. Zum Erzeugen der Teilstrukturen werden dann insbesondere aus dem wenigstens einen Belichtungsdatensatz bzw. dem wenigstens einen Korrektur-Belichtungsdatensatz weitere Teilbelichtung-Datensätze rechnergestützt ermittelt, welche für jede Teilstruktur eine lokale Belichtungsdosis für eine Scan-Mannigfaltigkeit repräsentieren. Insbesondere wird nach dem Definieren einer jeweiligen Teilstruktur der Schreibbereich der Laserlithographie-Vorrichtung verlagert, bspw. mittels aus dem Stand der Technik bekannten Positionierungsmitteln.

Grundsätzlich können die Teilstrukturen verschiedene Formen aufweisen. Falls die zu erzeugende Zielstruktur eine Erstreckung in Höhenrichtung aufweist, welche größer als eine maximale Schreibhöhe der Laserlithographie-Vorrichtung ist, kann es insbesondere vorteilhaft sein, wenn die Zielstruktur zumindest abschnittsweise in schichtartig aufeinandergestapelte Teilstrukturen zerlegt wird. Insofern ist zumindest eine Teilmenge der Teilstrukturen derart ausgebildet ist, dass die Zielstruktur durch eine Mehrzahl von schichtartig aufeinander gestapelten, also in Höhenrichtung übereinanderliegenden, Teilstrukturen angenähert wird. Dann wird nach dem Schreiben einer jeweiligen Teilstruktur das Lithographiematerial bzw. ein Substrat mit dem Lithographiematerial insbesondere mittels einer Positioniereinrichtung kontrolliert nach unten gefahren.

Gemäß einer vorteilhaften Weiterbildung können der wenigstens eine Belichtungsdatensatz und der wenigstens eine Korrektur-Belichtungsdatensatz jeweils wenigstens einen Graustufen-Bilddatensatz umfassen, wobei verschiedene Graustufen verschiedene Belichtungsdosen repräsentieren. Insbesondere bestehen der wenigstens eine Belichtungsdatensatz und der wenigstens eine Korrektur-Belichtungsdatensatz jeweils aus einem Graustufen-Bilddatensatz. Die Datensätze sind insofern als GraustufenBilder visualisierbar. Insbesondere wird die Laserlithographie-Vorrichtung gemäß den Graustufen-Bilddatensätzen gesteuert. Vorzugsweise wird der wenigstens eine Belichtungsdatensatz dadurch bereitgestellt, dass eine Graustufen-Bilddatei in einer Steuereinrichtung der Laserlithographie-Vorrichtung eingelesen und in einem Speicher hinterlegt wird.

Wird die Zielstruktur wie vorstehend erläutert durch schichtartig aufeinandergestapelte Teilstrukturen aufgebaut, so werden, im Falle einer Ausgestaltung des wenigstens einen Belichtungsdatensatzes und des wenigstens einen Korrektur-Belichtungsdatensatzes als Graustufen-Bilddatensatz, zum Ermitteln der Teilbelichtung-Datensätze für die Teilstrukturen der Graustufen-Bilddatensatz des wenigstens einen Belichtungsdatensatzes bzw. der Graustufen-Bilddatensatz des wenigstens einen Korrektur-Belichtungsdatensatzes in eine Mehrzahl von Teil-Graustufen-Bilddatensätzen aufgespalten. Die Teil-Graustufen-Bilddatensätze repräsentieren dann zusammen einen Bilderstapel entlang der Stapelrichtung der Teilstrukturen. Die höchste Graustufe eines jeweiligen Graustufenbildes entspricht dann einer Belichtungsdosis, welche zu einer maximalen Strukturhöhe führt, die mit der Laserlithographie-Vorrichtung in einer Ebene (also ohne dass das Lithographiematerial in Höhenrichtung relativ zu dem Fokusbereich des Laser-Schreibstrahls verfahren werden muss) geschrieben werden kann.

Gemäß einer vorteilhaften Weiterbildung kann auch der wenigstens eine Analysedatensatz wenigstens einen Graustufen-Bilddatensatz umfassen, insbesondere daraus bestehen, wobei verschiedene Graustufen verschiedene Strukturhöhen der analysierten Struktur repräsentieren. Dann kann der Abweichungsdatensatz, insbesondere auch der Korrektur-Belichtungsdatensatz, durch Vergleich des wenigstens einen Analysedatensatzes mit dem wenigstens einen Belichtungsdatensatzes ermittelt werden.

Die eingangs gestellte Aufgabe wird auch durch eine Laserlithographie-Vorrichtung gemäß Anspruch 12 gelöst. Die Laserlithographie-Vorrichtung ist zum Erzeugen einer dreidimensionalen Zielstruktur in einem Lithographiematerial ausgebildet. Die Laserlithographie-Vorrichtung umfasst eine Laserquelle zur Aussendung eines Laser-Schreibstrahls. Außerdem umfasst die Laserlithographie-Vorrichtung eine Strahlführungseinrichtung, insbesondere umfassend Optikmittel wie Linsen, Spiegel, etc., zur Definition eines Strahlengangs für den Laser-Schreibstrahl von der Laserquelle zu dem Lithographiematerial. Außerdem ist eine Fokussieroptik vorgesehen, welche dazu ausgebildet ist, den Laser-Schreibstrahl in einen Fokusbereich zu fokussieren. Zur Verlagerung des Fokusbereiches des Laser-Schreibstrahls relativ zu dem Lithographiematerial ist außerdem eine Scan-Einrichtung vorgesehen. Die Scan-Einrichtung kann eine Ablenkeinrichtung (z.B. umfassend Ablenkspiegel) zur Veränderung einer Position des Fokusbereichs des Laser-Schreibstrahls in dem Lithographiematerial sein. Zusätzlich oder alternativ kann die Scan-Einrichtung auch eine Positioniereinrichtung umfasst, mittels derer das Lithographiematerial oder ein Substrat mit dem Lithographiematerial relativ zu dem Laser-Schreibstrahl verlagerbar ist.

Die Laserlithographie-Vorrichtung umfasst außerdem eine bildgebende Messeinrichtung zur Analyse einer in dem Lithographiematerial mittels des Laser-Schreibstrahls definierten bzw. geschriebenen Struktur. Die Messeinrichtung kann insbesondere eine Detektionseinrichtung zur Detektion von Strahlung umfassen, welche von der zu analysierenden Struktur rückgestreut, reflektiert, transmittiert oder durch Fluoreszenz erzeugt wurde. Zusätzlich oder alternativ ist es möglich, dass die Messeinrichtung eine Sonde mit Abtastspitze umfasst, mittels welcher die Struktur mechanisch abgetastet werden kann.

Die Laserlithographie-Vorrichtung umfasst außerdem eine Steuereinrichtung, welche dazu eingerichtet ist, die vorstehend erläuterten Verfahren durchzuführen. Die Steuereinrichtung umfasst insbesondere eine Recheneinheit und einen nichtflüchtigen Speicher, in dem die vorstehend erläuterten Datensätze hinterlegt oder hinterlegbar sind.

Die Erfindung wird im Folgenden anhand der Figuren näher erläutert.

Es zeigen:
- Fig. 1: vereinfachte schematische Darstellung einer Laserlithographie-Vorrichtung;
- Fig. 2a, b: skizzierte Darstellungen zur Erläuterung von Teilschritten des Verfahrens zum Erzeugen einer dreidimensionalen Struktur;
- Fig. 3: schematisches Flussdiagramm einer Ausgestaltung des Verfahrens zum Erzeugen einer dreidimensionalen Struktur; und
- Fig. 4 und 5: skizzierte Darstellungen zur Erläuterung der Zerlegung des Belichtungsdatensatzes in Teil-Belichtungsdatensätze.

In der nachfolgenden Beschreibung sowie in den Figuren sind für identische oder einander entsprechende Merkmale jeweils dieselben Bezugszeichen verwendet.

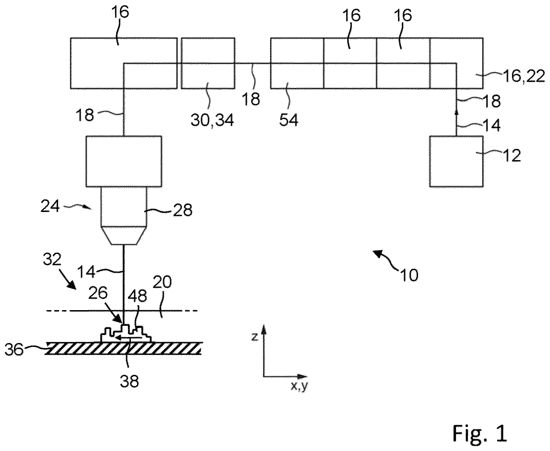

Die Fig. 1 zeigt in schematischer Darstellung eine Laserlithographie-Vorrichtung, welche insgesamt mit dem Bezugszeichen 10 bezeichnet ist. Die Laserlithographie-Vorrichtung 10 umfasst eine Laserquelle 12 zur Aussendung eines Laser-Schreibstrahls 14. Die Laserlithographie-Vorrichtung 10 umfasst außerdem eine Strahlführungseinrichtung 16 zur Definition eines Strahlengangs 18 für den Laser-Schreibstrahl 14 von der Laserquelle 12 zu einem zu strukturierenden Lithographiematerial 20, welches beispielhaft als Bad aus flüssigem Material dargestellt ist.

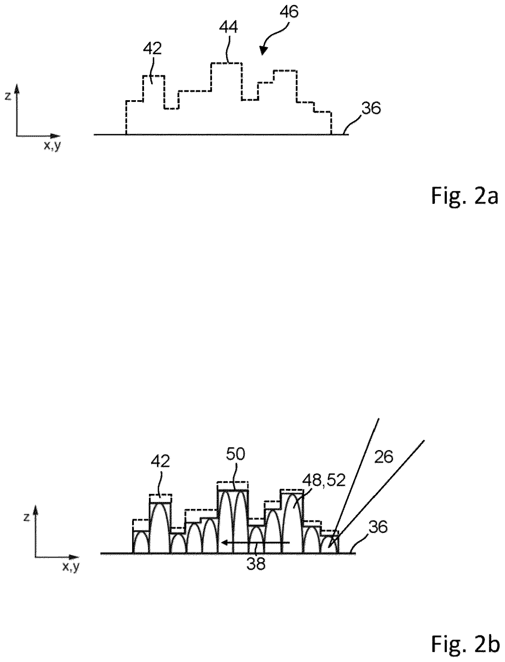

Die Strahlführungseinrichtung 16 weist in dem dargestellten Beispiel mehrere Module auf, welche optische und oder mechanische Funktionen erfüllen. Beispielsweise kann der Strahlengangs 16 zunächst durch ein Modulation-Modul 22 zur Formung von geeigneten Strahlpulsen verlaufen. Die Laserlithographie-Vorrichtung 10 umfasst außerdem eine Fokussieroptik 24 zur Fokussierung des Laser-Schreibstrahls 14 in einem Fokusbereich 26 (vgl. auch Fig. 2a) des Laser-Schreibstrahls 14. Die Fokussieroptik 24 umfasst beispielhaft ein Objektiv-Modul 28, durch welches der Laser-Schreibstrahl 14 in das Lithographiematerial 20 eingestrahlt wird.

In dem dargestellten Beispiel umfasst die Laserlithographie-Vorrichtung 10 außerdem eine Scan-Einrichtung 30 mittels derer der Fokusbereich 26 des Laser-Schreibstrahls 14 in einem Schreibbereich 32 relativ zu dem Lithographiematerial 20 mit einer zur Strukturierung erforderlichen Präzision verlagert werden kann. In dem dargestellten Beispiel umfasst die Scan-Einrichtung 30 ein Strahllenkungsmodul 34, welches beispielsweise eine Galvanometer-Scanner-Einheit zur kontrollierten Auslenkung des Laserstrahls 14 umfassen kann. Bei nicht dargestellten Ausführungsformen ist es auch möglich, dass die Scan-Einrichtung 30 eine Positioniereinrichtung umfasst, welche dazu dient, das Lithographiematerial 20 bzw. das Substrat 36 mit dem Lithographiematerial 20 relativ zu dem Fokusbereich 26 des Laser-Schreibstrahls 14 positionsgenau zu verfahren. In den Figuren ist auch ein Koordinatensystem dargestellt mit zueinander orthogonalen Achsen x, y, z, wobei die x-Achse und die y-Achse eine Schreibebene aufspannen und die z-Achse einer Höhenrichtung entspricht.

Die Laserlithographie-Vorrichtung 10 umfasst außerdem eine Steuereinrichtung (nicht dargestellt), welche eine Recheneinheit und einen nichtflüchtigen Speicher umfasst. Zum Erzeugen einer dreidimensionalen Struktur in dem Lithographiematerial wird der Fokusbereich 26 des Laser-Schreibstrahls 14 durch die Scan-Einrichtung 30 relativ zu dem Lithographiematerial 20 verlagert, sodass der Fokusbereich 26 eine Scan-Mannigfaltigkeit (in Figur 1 durch den Pfeil 38 dargestellt) durch das Lithographiematerial 20 durchläuft. In dem Fokusbereich 26 des Laser-Schreibstrahls 14 wird dabei lokal eine Belichtungsdosis in das Lithographiematerial 20 eingestrahlt, sodass lokal, unter Ausnutzung von Multi-Photonen-Absorption, Strukturbereiche 40 (vgl. Figur 2b) definiert werden. Beispielsweise wird das Lithographiematerial 20 lokal polymerisiert und somit strukturiert.

Eine vorteilhafte Ausgestaltung des Verfahrens zum Erzeugen einer dreidimensionalen Struktur mittels einer Laserlithographie-Vorrichtung, insbesondere mittels der vorstehend erläuterten Laserlithographie-Vorrichtung 10 wird im Folgenden anhand der Figuren 2a bis 5 erläutert.

Die Fig. 2a zeigt in einer Schnittansicht schematisch eine beispielhafte Zielstruktur, die mittels 3D-Laserlithographie in einem Volumen aus Lithographiematerial 20 geschrieben werden soll. Die Zielstruktur 42 ist in Figur 2a mit dem Bezugszeichen 42 bezeichnet und weist eine Außenfläche 44 auf, welche in Figur 2a strichliniert dargestellt ist. Die Zielstruktur 42 weist in dem dargestellten Beispiel ein ausgeprägtes Höhenprofil 46 auf, anhand dessen die Auswirkungen einer Veränderung der Belichtungsdosis erläutert werden soll. Selbstverständlich sind jedoch auch andere Geometrien denkbar. Beispielsweise kann die Außenfläche 44 der 42 auch einen Verlauf mit verschiedenen Steigungen oder auch Krümmungen aufweisen.

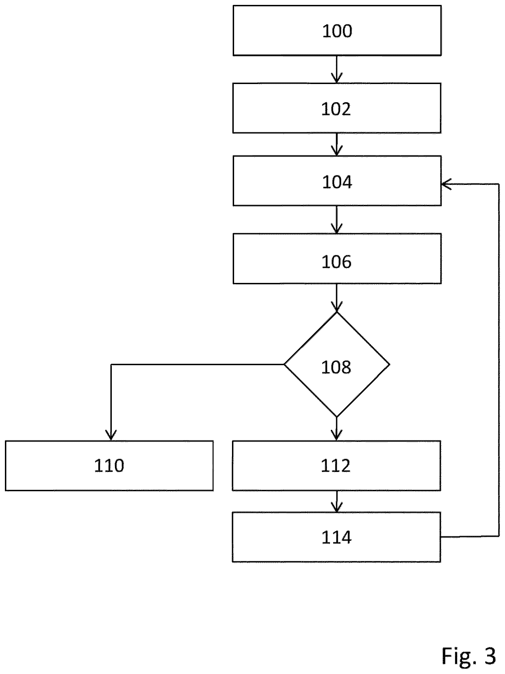

Zur lithographischen Herstellung der Zielstruktur 42 wird zunächst ein Belichtungsdatensatz bereitgestellt, welcher für die Scan-Mannigfaltigkeit 38 ortsabhängig eine lokale Belichtungsdosis repräsentiert (Schritt 100 in Fig. 3). Bei dem Belichtungsdatensatz kann es sich insbesondere um einen die Zielstruktur 42 repräsentierenden Graustufen-Bilddatensatz handeln. Beispielsweise ist es möglich, dass in der Steuereinrichtung der Laserlithographie-Vorrichtung 10 eine Graustufen-Bilddatei eingelesen wird. Es ist auch möglich, dass zunächst ein die Zielstruktur 42 repräsentieren der Strukturdatensatz bereitgestellt (z.B. CAD-Daten) wird und aus diesem Strukturdatensatz dann der Belichtungsdatensatz rechnergestützt ermittelt wird.

In einem nächsten Schritt (Schritt 102 in Fig. 3) wird sodann die Laserlithographie-Vorrichtung 10 gemäß dem Belichtungsdatensatz angesteuert, sodass eine die Zielstruktur 42 zumindest annähernde Struktur 48 erzeugt wird (eine Außenfläche dieser Struktur ist in Figur 2b mit durchgehenden Linien eingezeichnet und mit dem Bezugszeichen 50 bezeichnet). Wie in Figur 2a beispielhaft dargestellt, die Struktur 48 beispielsweise dadurch definiert werden, dass der Fokusbereich 26 eine Scan-Mannigfaltigkeit 38 durchläuft und dabei eine Folge von Laserpulsen mit einer definierten Pulsrate und Pulslänge abgibt. Dadurch wird entlang der Scan-Mannigfaltigkeit 38 eine Reihe von Strukturbereichen 52 (Voxeln) definiert, welche die Struktur 48 bilden. Die Strukturbereiche 52 sind untereinander formähnlich oder formidentisch. Die Größe eines geschriebenen Strukturbereichs 52 und somit eine Strukturhöhe hängt dabei mit der eingebrachten Belichtungsdosis zusammen.

Aufgrund von verschiedenen Effekten (z.B. lokal unterschiedliche Antwort des Lithographiematerials auf den Lasereintrag, Optikfehler, Neigung des Substrates 36, etc.) entspricht die auf Basis des Belichtungsdatensatzes erzeugte Struktur 48 in der Regel noch nicht exakt der gewünschten Zielstruktur 42. Gemäß dem Verfahren wird daher in einem weiteren Schritt (Schritt 104 in Fig. 3) die bereits definierte Struktur 48 analysiert, insbesondere die Topographie bzw. Form der definierten Struktur 48 gemessen. Dies erfolgt in-situ, also insbesondere ohne, dass das Lithographiematerial 20 bzw. die definierte Struktur 48 zunächst entwickelt wird. Gemäß einer ersten beispielhaften Ausgestaltung wird die definierte Struktur 48 mittels konfokaler Fluoreszenzmikroskopie untersucht, wobei die bereits definierte Struktur 48 zunächst mittels des Laser-Schreibstrahls 14 optisch abgetastet wird und dann das von der Probe abgegebenes Fluoreszenzsignal analysiert wird. Zu diesem Zweck kann dann die Laserlithographie-Vorrichtung 10 eine entsprechende Messeinrichtung 54 (vgl. Fig. 1), beispielsweise einen Fluoreszenz-Detektor aufweisen. Beispielhaft und bevorzugt verläuft ein Strahlengang des von der Probe der von der Probe ausgesendeten Strahlung entlang des Strahlengangs des Laser-Schreibstrahls.

Es ist auch möglich, dass zum Analysieren der Struktur 48 diese mittels einer Abtastspitze (nicht dargestellt) mechanisch abgetastet wird. Dann kann die Laserlithographie-Vorrichtung 10 eine Abtastvorrichtung (nicht dargestellt) aufweisen.

Während und/oder nach dem Analysieren der Struktur 48 wird sodann ein Analysedatensatz ermittelt, welcher die definierte Struktur 48, insbesondere deren Topographie bzw. Form, repräsentiert. Beispielhaft und bevorzugt handelt es sich bei dem Analysedatensatz auch um einen Graustufen-Bilddatensatz, wobei verschiedene Graustufen verschiedene Strukturhöhen (in z-Richtung) repräsentieren.

In einem weiteren Schritt (Schritt 106 in Fig. 3) wird nun durch Vergleich des die Zielstruktur 42 repräsentierenden Belichtungsdatensatzes und des Analysedatensatzes ein Abweichungsdatensatz ermittelt, welcher Abweichungen der bereits definierten Struktur 48 von der Zielstruktur 42 (vgl. Fig. 2b) repräsentiert. Insbesondere kann der Abweichungsdatensatz durch Differenz der Graustufen-Bilddatensätze des Belichtungsdatensatzes und des Analysedatensatzes ermittelt werden.

Anschließend wird überprüft, ob die ermittelte Abweichung einen vorgegebenen Schwellwert unterschreitet oder nicht (Schritt 108 in Fig. 3). Es wird also überprüft, ob die bereits definierte Struktur 48 der gewünschten Zielstruktur 42 bereits hinreichend entspricht. Ist dies der Fall, wird das Verfahren beendet (Schritt 110 in Fig. 3). Liegt die Abweichung allerdings oberhalb des Schwellwerts, wird in einem weiteren Schritt auf Basis des Abweichungsdatensatzes ein Korrektur-Belichtungsdatensatz ermittelt (Schritt 112 in Fig. 3), welcher für jeden Scanpunkt der Scan-Mannigfaltigkeit 38 eine korrigierte Belichtungsdosis repräsentiert, um die Abweichungen von der Zielstruktur 42 auszugleichen oder zumindest zu verringern.

In einem weiteren Schritt wird die Laserlithographie-Vorrichtung 10 dann auf Basis des Korrektur-Belichtungsdatensatzes angesteuert (Schritt 114 in Fig. 3), sodass eine Korrekturstruktur definiert wird. Es ist möglich, dass auf Basis des Korrektur-Belichtungsdatensatzes eine "neue", von der auf Basis des Belichtungsdatensatzes definierten Struktur räumlich getrennte Struktur erzeugt wird, insbesondere an einer abweichenden Position auf dem Substrat 36. Es ist auch möglich, dass die Korrekturstruktur lediglich der Nachkorrektur der zuvor auf Basis des wenigstens einen Belichtungsdatensatzes geschriebenen Struktur dient. Dann kann der Fokusbereich 26 des Laser-Schreibstrahls 14 insbesondere erneut die zuvor durchlaufene Scan-Mannigfaltigkeit 38 durchlaufen, wobei ortsabhängig die entsprechend angepasste Belichtungsdosis gemäß dem Korrektur-Belichtungsdatensatzes eingestrahlt wird.

Die Schritte 104 bis 114 werden iterativ wiederholt, bis eine ermittelte Abweichung der tatsächlich erzeugten Struktur 48 und der gewünschten Zielstruktur 42 den Schwellwert unterschreitet.

Ist die gewünschte Zielstruktur 42 größer als der maximale Schreibbereich 34 der Laserlithographie-Vorrichtung 10, kann die Zielstruktur 42 rechentechnisch in die Zielstruktur 42 zusammen annähernde Teilstrukturen zerlegt werden. Zum Erzeugen der Teilstrukturen werden dann insbesondere aus dem wenigstens einen Belichtungsdatensatz weitere Teilbelichtung-Datensätze rechnergestützt ermittelt, welche für jede Teilstruktur eine lokale Belichtungsdosis für eine Scan-Mannigfaltigkeit 38 repräsentieren. Anschließend werden die Teilstrukturen sequentiell geschrieben und die sich daraus ergebende Struktur gemäß dem vorstehend erläuterten Verfahren analysiert und optimiert. Hierbei wird optional auch der Analysedatensatz, der Abweichungsdatensatz und/oder der Korrektur-Belichtungsdatensatz in Teil-Datensätze gemäß den Teilstrukturen zerlegt.

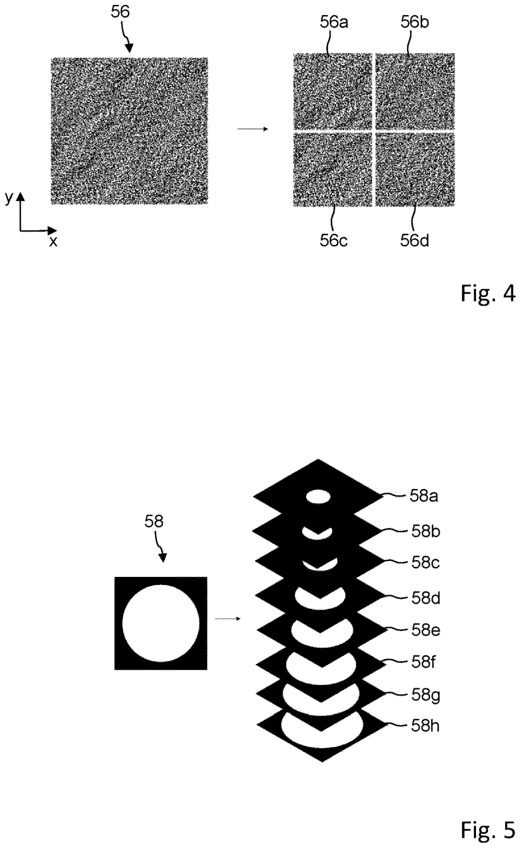

Fig. 4 visualisiert den beispielhaften Fall, dass die Zielstruktur eine größere Erstreckung in der Scanebene (x-y-Ebene) aufweist als der Schreibbereich 34 der Laserlithographie-Vorrichtung 10. In Fig. 4 ist beispielhaft ein den Belichtungsdatensatz repräsentierendes Graustufenbild 56 dargestellt. Wie in Fig. 4 beispielhaft dargestellt, kann das Graustufenbild 56 bzw. der Belichtungsdatensatz in Teil-Graustufenbilder 56a-d bzw. Teil-Graustufen-Bilddatensätze zerlegt werden, auf Basis derer die Teilstrukturen dann geschrieben werden.

Für den Fall, dass eine Erstreckung der Zielstruktur 42 in Höhenrichtung (z-Richtung) größer ist als eine maximale Schreibhöhe der Laserlithographie-Vorrichtung 10 pro Scanebene, kann die Zielstruktur 42 beispielsweise in schichtartig aufeinandergestapelte Teilstrukturen zerlegt werden. Dieser Fall ist in Fig. 5 skizzenhaft visualisiert. Zum Definieren der Teilstrukturen kann dann der Belichtungsdatensatz (in Fig. 5 durch das Graustufenbild 58 visualisiert) in eine Mehrzahl von Teil-Belichtungsdatensätzen (in Fig. 5 durch einen Stapel aus entsprechenden Graustufenbilden 58a-h visualisiert) zerlegt werden. Die Graustufenbilder 58 bzw. 58a-h sind in Figur 5 lediglich skizzenhaft zur Erläuterung des Bilder-Stacks dargestellt. Insbesondere entspricht jedoch jedes Graustufenbild 58 bzw. 58a-h in Figur 5 einem Bild in der Art der in Figur 4 dargestellten Graustufenbilder 56.

## Patentansprüche

1. Verfahren zum Erzeugen einer dreidimensionalen Zielstruktur (42) in einem Lithographiematerial (20) mittels einer Laserlithographie-Vorrichtung (10), wobei die Zielstruktur (42) dadurch definiert wird, dass innerhalb eines Schreibbereichs (34) der Laserlithographie-Vorrichtung (10) ein Fokusbereich (26) eines Laser-Schreibstrahls (14) eine Scan-Mannigfaltigkeit (38), die eine Scan-Kurve ist, durch das Lithographiematerial (20) durchläuft, wobei in dem Fokusbereich (26) des Laser-Schreibstrahls (14) eine Belichtungsdosis in das Lithographiematerial (20) eingestrahlt wird und unter Ausnutzung von Multi-Photonen-Absorption lokal ein Strukturbereich (52) definiert wird, das Verfahren umfassend:
a) Bereitstellen wenigstens eines Belichtungsdatensatzes, welcher für die Scan-Mannigfaltigkeit (38) ortsabhängig eine lokale Belichtungsdosis repräsentiert;
b) Definieren einer die Zielstruktur (42) annähernden Struktur (48) auf Basis des wenigstens einen Belichtungsdatensatzes;
c) Analysieren der bereits definierten Struktur (48) mittels eines ortsauflösenden bildgebenden Messverfahrens und Ermitteln wenigstens eines Analysedatensatzes, welcher die analysierte Struktur (48) repräsentiert;
d) Ermitteln eines Abweichungsdatensatzes, welcher Abweichungen der bereits definierten Struktur (48) von der Zielstruktur (42) repräsentiert;
e) Ermitteln wenigstens eines Korrektur-Belichtungsdatensatzes, welcher für die Scan-Mannigfaltigkeit (38) ortsabhängig eine zum Ausgleich der Abweichungen erforderliche Korrektur-Belichtungsdosis repräsentiert;
f) Definieren einer Korrekturstruktur auf Basis des wenigstens einen Korrektur-Belichtungsdatensatzes.

2. Verfahren nach Anspruch 1, wobei zwischen dem Definieren der Struktur (48) (Schritt b) und dem Analysieren der Struktur (48) (Schritt c) keine Entwicklung des Lithographiematerials (20) erfolgt.

3. Verfahren nach einem der Ansprüche 1 oder 2, wobei die Schritte c) bis f) derart iterativ wiederholt werden, dass die Abweichung der bereits definierten Struktur (48) von der Zielstruktur (42) zunehmend verringert wird, insbesondere bis die ermittelte Abweichung einen vorgegebenen oder vorgebbaren Schwellwert unterschreitet.

4. Verfahren nach einem der vorherigen Ansprüche, wobei das Analysieren der definierten Struktur (48) mittels optischer Mikroskopie, insbesondere mittels konfokaler Fluoreszenzmikroskopie erfolgt.

5. Verfahren nach Anspruch 4, wobei zum Analysieren der bereits definierten Struktur (48) diese mit dem Laser-Schreibstrahl (14) abgetastet wird und zur Bildgebung die rückgestreute, reflektierte, transmittierte oder durch Fluoreszenz erzeugte Strahlung mittels einer Messeinrichtung (54) detektiert wird, insbesondere wobei eine Belichtungsdosis zum Abtasten derart niedrig gewählt ist, dass keine Struktur in dem Lithographiematerial (20) definiert wird.

6. Verfahren nach einem der Ansprüche 1 bis 3, wobei zum Analysieren der bereits definierten Struktur (48) diese mit einer Abtastspitze mechanisch abgetastet wird.

7. Verfahren nach einem der vorherigen Ansprüche, wobei die Zielstruktur (42) dadurch definiert wird, dass sequentiell eine Mehrzahl von Teilstrukturen definiert werden, welche zusammen die Zielstruktur (42) annähern, wobei zum Definieren der Teilstrukturen aus dem wenigstens einen Belichtungsdatensatz bzw. wenigstens einen dem Korrektur-Belichtungsdatensatz weitere Teilbelichtungs-Datensätze rechnergestützt ermittelt werden, welche für jede Teilstruktur eine lokale Belichtungsdosis entlang einer Scan-Mannigfaltigkeit, die eine Scan-Kurve ist, repräsentieren.

8. Verfahren nach Anspruch 7, wobei die Teilstrukturen schichtartig aufeinandergestapelt sind.

9. Verfahren nach einem der vorherigen Ansprüche, wobei der wenigstens eine Belichtungsdatensatz und der wenigstens eine Korrektur-Belichtungsdatensatz jeweils wenigstens einen Graustufen-Bilddatensatz umfassen, wobei verschiedene Graustufen verschiedene Belichtungsdosen repräsentieren.

10. Verfahren nach den Ansprüchen 7 bis 9, wobei zum Ermitteln der Teilbelichtungs-Datensätze der wenigstens eine Graustufen-Bilddatensatz des wenigstens einen Belichtungsdatensatzes und/oder des wenigstens einen Korrektur-Belichtungsdatensatzes in eine Mehrzahl von Teil-Graustufen-Bilddatensätzen aufgespalten wird, welche zusammen einen Bilderstapel (58a-h) entlang der Stapelrichtung der Teilstrukturen repräsentieren.

11. Verfahren nach einem der Ansprüche 9 oder 10, wobei der wenigstens eine Analysedatensatz ebenfalls wenigstens einen Graustufen-Bilddatensatz umfasst, wobei verschiedene Graustufen verschiedene Strukturhöhen repräsentieren und wobei der Abweichungsdatensatz durch Vergleich des wenigstens einen Analysedatensatzes mit dem wenigstens einen Belichtungsdatensatz ermittelt wird.

12. Laserlithographie-Vorrichtung (10) zum Erzeugen einer dreidimensionalen Zielstruktur (42) in einem Lithographiematerial (20), umfassend eine Laserquelle (12) zur Aussendung eines Laser-Schreibstrahls (14), eine Strahlführungseinrichtung (16) zur Definition eines Strahlengangs (18) für den Laser-Schreibstrahl (14) von der Laserquelle (12) zu dem Lithographiematerial (20), eine Fokussieroptik (24) zur Fokussierung des Laser-Schreibstrahls (14) in einem Fokusbereich (26), eine Scan-Einrichtung (30) zur Verlagerung des Fokusbereiches (26) des Laser-Schreibstrahls (14) relativ zu dem Lithographiematerial (20), eine bildgebende Messeinrichtung (54) zur Analyse einer bereits definierten Struktur (48) und eine Steuereinrichtung, welche dazu eingerichtet ist, das Verfahren nach einem der Ansprüche 1 bis 11 auszuführen.

## Claims

1. Method for producing a three-dimensional target structure (42) in a lithographic material (20) by means of a laser lithography device (10), wherein the target structure (42) is defined in that, within a writing region (34) of the laser lithography device (10), a focus region (26) of a laser writing beam (14) passes through a scan manifold (38), which is a scan curve, through the lithographic material (20), wherein an exposure dose is radiated into the lithographic material (20) in the focus region (26) of the laser writing beam (14) and a structure region (52) is defined locally using multi-photon absorption, the method comprising:
a) providing at least one exposure data set which represents a local exposure dose for the scan manifold (38) depending on the location;
b) defining a structure (48) approximating the target structure (42) on the basis of the at least one exposure data set;
c) analyzing the already defined structure (48) by means of a spatially resolving imaging measurement method and determining at least one analysis data set which represents the analyzed structure (48);
d) determining a deviation data set which represents deviations of the already defined structure (48) from the target structure (42);
e) determining at least one correction exposure data set which represents a correction exposure dose required to compensate for the deviations for the scan manifold (38) depending on the location;
f) defining a correction structure on the basis of the at least one correction exposure data set.

2. Method according to claim 1, wherein no development of the lithographic material (20) occurs between defining the structure (48) (step b) and analyzing the structure (48) (step c).

3. Method according to claim 1 or 2, wherein steps c) to f) are repeated iteratively in such a way that the deviation of the already defined structure (48) from the target structure (42) is increasingly reduced, in particular until the determined deviation falls below a specified or specifiable threshold value.

4. Method according to any of the preceding claims, wherein the defined structure (48) is analyzed by means of optical microscopy, in particular by means of confocal fluorescence microscopy.

5. Method according to claim 4, wherein, in order to analyze the already defined structure (48), the structure is scanned by the laser writing beam (14) and, for imaging, the backscattered, reflected, transmitted or fluorescence-generated radiation is detected by means of a measuring device (54), in particular wherein an exposure dose for scanning is selected to be low enough that no structure is defined in the lithographic material (20).

6. Method according to any of claims 1 to 3, wherein, in order to analyze the already defined structure (48), the structure is mechanically scanned by a scanning tip.

7. Method according to any of the preceding claims, wherein the target structure (42) is defined by sequentially defining a plurality of partial structures, which together approximate the target structure (42), wherein, in order to define the partial structures, further partial exposure data sets are determined in a computer-assisted manner from the at least one exposure data set and/or at least one the correction exposure data set, which partial exposure data sets represent a local exposure dose along a scan manifold, which is a scan curve, for each partial structure.

8. Method according to claim 7, wherein the partial structures are stacked on top of one another in layers.

9. Method according to any of the preceding claims, wherein the at least one exposure data set and the at least one correction exposure data set each comprise at least one grayscale image data set, wherein different gray levels represent different exposure doses.

10. Method according to claims 7 to 9, wherein, in order to determine the partial exposure data sets, the at least one grayscale image data set of the at least one exposure data set and/or the at least one correction exposure data set is divided into a plurality of partial grayscale image data sets which together represent an image stack (58a-h) in the stacking direction of the partial structures.

11. Method according to claim 9 or 10, wherein the at least one analysis data set also comprises at least one grayscale image data set, wherein different gray levels represent different structure heights, and wherein the deviation data set is determined by comparing the at least one analysis data set with the at least one exposure data set.

12. Laser lithography device (10) for producing a three-dimensional target structure (42) in a lithographic material (20), comprising a laser source (12) for emitting a laser writing beam (14), a beam guide device (16) for defining a beam path (18) for the laser writing beam (14) from the laser source (12) to the lithographic material (20), focusing optics (24) for focusing the laser writing beam (14) in a focus region (26), a scanning device (30) for shifting the focus region (26) of the laser writing beam (14) relative to the lithographic material (20), an imaging measuring device (54) for analyzing an already defined structure (48), and a control device which is configured to carry out the method according to any of claims 1 to 11.

## Revendications

1. Procédé permettant la production d'une structure cible (42) tridimensionnelle dans un matériau lithographique (20) au moyen d'un dispositif de lithographie laser (10), dans lequel la structure cible (42) est définie par le fait qu'à l'intérieur d'une région d'écriture (34) du dispositif de lithographie laser (10), une région focale (26) d'un faisceau laser d'écriture (14) parcourt une multiplicité de balayage (38), laquelle est une courbe de balayage, à travers le matériau lithographique (20), dans lequel, dans la région focale (26) du faisceau laser d'écriture (14), une dose d'exposition lumineuse est irradiée dans le matériau lithographique (20) et une région structurelle (52) est définie localement en utilisant une absorption multiphotonique, le procédé comprenant:
a) la mise à disposition d'au moins un jeu de données d'exposition lumineuse qui représente une dose d'exposition lumineuse locale pour la multiplicité de balayage (38) en fonction de l'emplacement;
b) la définition d'une structure (48) approchant la structure cible (42) sur la base de l'au moins un jeu de données d'exposition lumineuse;
c) l'analyse de la structure (48) déjà définie au moyen d'un procédé de mesure par imagerie à résolution spatiale et la détermination d'au moins un jeu de données d'analyse qui représente la structure (48) analysée ;
d) la détermination d'un jeu de données d'écarts qui représente des écarts de la structure (48) déjà définie par rapport à la structure cible (42);
e) la détermination d'au moins un jeu de données d'exposition lumineuse de correction qui représente, pour la multiplicité de balayage (38), en fonction de l'emplacement, une dose d'exposition lumineuse de correction nécessaire à la compensation des écarts;
f) la définition d'une structure de correction sur la base de l'au moins un jeu de données d'exposition lumineuse de correction.

2. Procédé selon la revendication 1, dans lequel aucun développement du matériau lithographique (20) n'est effectué entre la définition de la structure (48) (étape b) et l'analyse de la structure (48) (étape c).

3. Procédé selon l'une des revendications 1 ou 2, dans lequel les étapes c) à f) sont répétées de manière itérative de telle sorte que l'écart entre la structure (48) déjà définie et la structure cible (42) est progressivement réduit, en particulier jusqu'à ce que l'écart déterminé soit inférieur à une valeur seuil préréglée ou pouvant être préréglée.

4. Procédé selon l'une des revendications précédentes, dans lequel l'analyse de la structure (48) définie est effectuée au moyen d'une microscopie optique, en particulier au moyen d'une microscopie confocale à fluorescence.

5. Procédé selon la revendication 4, dans lequel, pour l'analyse de la structure (48) déjà définie, celle-ci est balayée par le faisceau laser d'écriture (14) et, pour l'imagerie, le rayonnement rétrodiffusé, réfléchi, transmis ou produit par fluorescence est détecté au moyen d'un appareil de mesure (54), en particulier dans lequel une faible dose d'exposition lumineuse est choisie pour le balayage de telle sorte qu'aucune structure n'est définie dans le matériau lithographique (20) .

6. Procédé selon l'une des revendications 1 à 3, dans lequel, pour l'analyse de la structure (48) déjà définie, celle-ci est balayée mécaniquement avec une pointe de balayage.

7. Procédé selon l'une des revendications précédentes, dans lequel la structure cible (42) est définie en définissant séquentiellement une pluralité de structures partielles qui approchent conjointement la structure cible (42), dans lequel, pour la définition des structures partielles à partir de l'au moins un jeu de données d'exposition lumineuse ou d'au moins un le jeu de données d'exposition lumineuse de correction, d'autres jeux de données d'exposition lumineuse partielle sont déterminés par ordinateur, lesquels représentent pour chaque structure partielle une dose d'exposition lumineuse locale le long d'une multiplicité de balayage qui est une courbe de balayage.

8. Procédé selon la revendication 7, dans lequel les structures partielles sont empilées les unes sur les autres à la manière de couches.

9. Procédé selon l'une des revendications précédentes, dans lequel l'au moins un jeu de données d'exposition lumineuse et l'au moins un jeu de données d'exposition lumineuse de correction comprennent respectivement au moins un jeu de données d'image en niveaux de gris, dans lequel différents niveaux de gris représentent différentes doses d'exposition lumineuse.

10. Procédé selon les revendications 7 à 9, dans lequel, pour la détermination des jeux de données d'exposition lumineuse partielle, l'au moins un jeu de données d'image en niveaux de gris de l'au moins un jeu de données d'exposition lumineuse et/ou de l'au moins un jeu de données d'exposition lumineuse de correction est fractionné en une pluralité de jeux de données d'images en niveaux de gris partiels qui représentent conjointement une pile d'images (58a-h) le long de la direction d'empilement des structures partielles.

11. Procédé selon l'une des revendications 9 ou 10, dans lequel l'au moins un jeu de données d'analyse comprend également au moins un jeu de données d'image en niveaux de gris, dans lequel différents niveaux de gris représentent différentes hauteurs de structure, et dans lequel le jeu de données d'écarts est déterminé en comparant l'au moins un jeu de données d'analyse à l'au moins un jeu de données d'exposition lumineuse.

12. Dispositif de lithographie laser (10) permettant la production d'une structure cible (42) tridimensionnelle dans un matériau lithographique (20), comprenant une source laser (12) pour l'émission d'un faisceau laser d'écriture (14), un appareil de guidage de faisceau (16) pour la définition d'une trajectoire de faisceau (18) pour le faisceau laser d'écriture (14) depuis la source laser (12) jusqu'au matériau lithographique (20), une optique focalisatrice (24) pour la focalisation du faisceau laser d'écriture (14) dans une région focale (26), un appareil de balayage (30) pour le déplacement de la région focale (26) du faisceau laser d'écriture (14) par rapport au matériau lithographique (20), un appareil de mesure (54) par imagerie pour l'analyse d'une structure (48) déjà définie et un appareil de commande qui est configuré pour exécuter le procédé selon l'une des revendications 1 à 11.
